# EUROPEAN PATENT APPLICATION

(11) **EP 4 494 884 A1**
(43) Date of publication of application: **22.01.2025**
(21) Application number: 24184156.8
(22) Date of filing: 25.06.2024
(51) Int. Cl.: B41J 2/44, B23K 1/00, H05K 1/03, H05K 3/04

(54) **LASER-ASSISTED DEPOSITION WITH IMPROVED COATING**

(30) Priority: 21.07.2023 GB 202311278
(71) Applicant: ASMPT SMT Singapore Pte. Ltd., Singapore 768924 (SG)
(72) Inventor: ASHMORE, Clive, Weymouth, DT4 9DY (GB)
(74) Representative: Emerson, Peter James

(57) **Abstract**

A laser-assisted deposition apparatus for depositing deposition medium from a tape onto a workpiece, comprises a coating section with a deposition material source,
first and second regulating members arranged downstream of the deposition material source in spaced relation on either side of the tape such that the distance between the first and second regulating members regulates the thickness of deposition material coated onto the tape in use, and a vibration unit which is operative to agitate the deposition material at the coating section.

## Description

This invention relates to a laser-assisted deposition apparatus for depositing deposition medium from a tape onto a workpiece, and to a method for depositing deposition medium from a tape onto a workpiece.

### Background and Prior Art

Laser-assisted deposition (LAD) is a developing technology for depositing deposition material, in particular solder paste, onto a workpiece or substrate, and may be considered as an alternative to conventional paste deposition technologies such as screen-printing. LAD processes are characterised by the use of flexible tape which has paste applied to one side thereof. A laser is directed to irradiate an area of the opposite, i.e. uncoated, side of the tape, which causes a small volume of paste to be ejected from the coated side aligned with the irradiation area. The ejected paste volume may then land on the workpiece at an aligned target location. There are two main benefits to such an approach in comparison to conventional screen-printing processes: firstly, since the quantity of paste ejected from the tape is controlled by use of a laser, the paste deposited may potentially be controlled more accurately, and in smaller quantities, than with screen-printing; and secondly it is more readily possible to deposit additional paste onto a previously-deposited target, meaning that the height of the paste deposit may be accurately controlled.

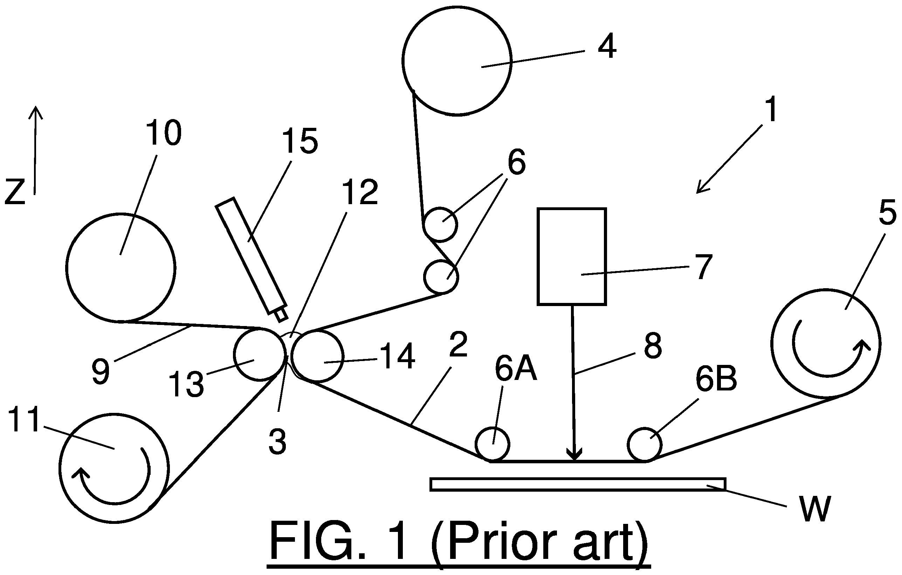

A typical LAD apparatus 1 is schematically shown, from the side, in FIG. 1, for use in depositing a deposition medium, most typically solder paste 3, from a deposition tape 2 onto a workpiece W, with the Z axis shown pointing vertically upwards. Typically, the deposition tape 2 is a flexible plastics material, such as, for example, polyethylene naphthalate (PEN), polyethylene terephthalate (PET), polyimide (PI), or flexible glass, etc., or a composite of more than one such material, for example layered materials. The deposition tape 2, prior to coating with solder paste 3, may be stored on a deposition tape store reel 4. Prior to deposition, the deposition tape 2 is threaded to a used tape reel 5, which is rotatably driven to advance the deposition tape 2, so that driving of the used tape reel 5 causes the deposition tape 2 to unwind from the deposition tape store reel 4 and wind around the used tape reel 5. Various rollers 6 may be used to define the deposition tape path and provide tensioning of the deposition tape 2. In particular, two rollers 6A, 6B are used to maintain a region of the deposition tape 2 close to and parallel to the upper surface of the workpiece W. A laser source 7, which may comprise various types of laser source such as, for example, a Nd:YAG laser source, an Nd:YLF laser source, an Nd:YVO4 laser source, an Nd:GdVO4 laser source, a Yb:YAG laser source, an Er:YAG laser source, an Er:Cr:YSGG laser source, an Er:YSGG laser source and a Gd:WO4 laser source, is located above this region, aligned so as to illuminate a spot on the upper surface of the deposition tape 2 between rollers 6A, 6B with a laser beam 8. The underside of the deposition tape 2 is coated with solder paste 3 by using a coating tape 9 which is fed from a coating tape store reel 10 to a coating tape used reel 11, the coating tape used reel 11 being rotatably drivable to advance the coating tape 9. The coating tape 9 may comprise a flexible plastics material, and may advantageously be of a similar construction to the deposition tape 2, with the exception that the deposition tape 2 is provided with a hydrophilic surface and the coating tape with a hydrophobic surface. The coating tape 9 and deposition tape 2 are diverted to a paste application zone 12, formed between first and second regulating members in the form of rollers 13, 14, at which there is a very small gap between the coating tape and the underside of the deposition tape 2. Solder paste 3 is released into the paste application zone 12 from a paste dispenser 15 so that a mass of solder paste 3 is formed between the rollers 13, 14. As the deposition tape 2 and coating tape 9 move past the paste application zone 12, the hydrophilic underside of the deposition tape 2 becomes coated with solder paste 3, with the thickness of the coating controlled by the distance between rollers 13, 14, with the hydrophobic surface of the coating tape 9 remaining substantially paste-free. It will be appreciated that the terms "hydrophobic" and "hydrophilic" properly apply to water-based fluids rather than flux-based fluids such as solder paste, but in practice solder paste exhibits similar wetting properties.

However, a problem exists with such known apparatus in that the coating process is relatively slow, and can also produce uneven paste coating across the surface of the deposition tape 4.

The present invention seeks to improve both throughput and coating uniformity.

In accordance with the present invention this aim is achieved by using vibrational agitation, in particular by using ultrasonic vibration, to temporarily reduce the viscosity of deposition medium such as solder paste during coating. This invention therefore takes advantage of the thixotropic nature of the deposition medium to reduce the viscosity of the medium at a coating section of the LAD apparatus.

### Summary of the Invention

In accordance with a first aspect of the present invention there is provided a laser-assisted deposition apparatus for depositing deposition medium from a tape onto a workpiece, the tape having two major surfaces, the laser-assisted deposition apparatus comprising:
a tape advancement mechanism for moving the tape through the laser-assisted deposition apparatus along a movement path,
a coating section for coating a first major surface of the tape with deposition medium,
a laser source operative to direct a laser beam onto a second surface of the tape at an illumination region thereof, and
a workpiece support for supporting a workpiece proximate the first surface, such that deposition medium, located on the first surface thereof and in alignment with the illumination region, is expelled from the second surface onto the workpiece when the laser beam is directed to the illumination region,
wherein the coating section comprises:
   a deposition material source for applying deposition material to the first major surface,
   first and second regulating members arranged downstream of the deposition material source along the movement path, and in spaced relation on either side of the tape such that the distance between the first and second regulating members regulates the thickness of deposition material coated onto the first major surface of the tape in use, and
   a vibration unit which is operative to agitate the deposition material at the coating section.

In accordance with a second aspect of the present invention there is provided a method for depositing deposition medium from a tape onto a workpiece, the tape having two major surfaces, the method comprising the steps:
i) providing a laser-assisted deposition apparatus,
ii) moving the tape through the laser-assisted deposition apparatus along a movement path,
iii) coating a first major surface of the tape with deposition medium at a coating section of the laser-assisted deposition apparatus, and
iv) directing a laser beam onto a second surface of the tape at an illumination region thereof, such that deposition medium, located on the first surface thereof and in alignment with the illumination region, is expelled from the second surface onto the workpiece when the laser beam is directed to the illumination region,

wherein step iii) comprises applying deposition material to the first major surface,
passing the tape with deposition material applied to the first major surface between first and second regulating members, to regulate the thickness of deposition material coated onto the first major surface of the tape, and
agitating the deposition material at the coating section.

Other specific aspects and features of the present invention are set out in the accompanying claims.

### Brief Description of the Drawings

The invention will now be described with reference to the accompanying drawings (not to scale), in which:
FIG. 1 schematically shows, from the side, a known LAD apparatus;
FIG. 2 schematically shows, from the side, a LAD apparatus in accordance with a first embodiment of the present invention;
FIG. 3 schematically shows, in an expanded vierw from the side, a LAD apparatus in accordance with a second embodiment of the present invention; and
FIG. 4 schematically shows, from the side, a LAD apparatus in accordance with a third embodiment of the present invention.

### Detailed Description of the Preferred Embodiments of the Invention

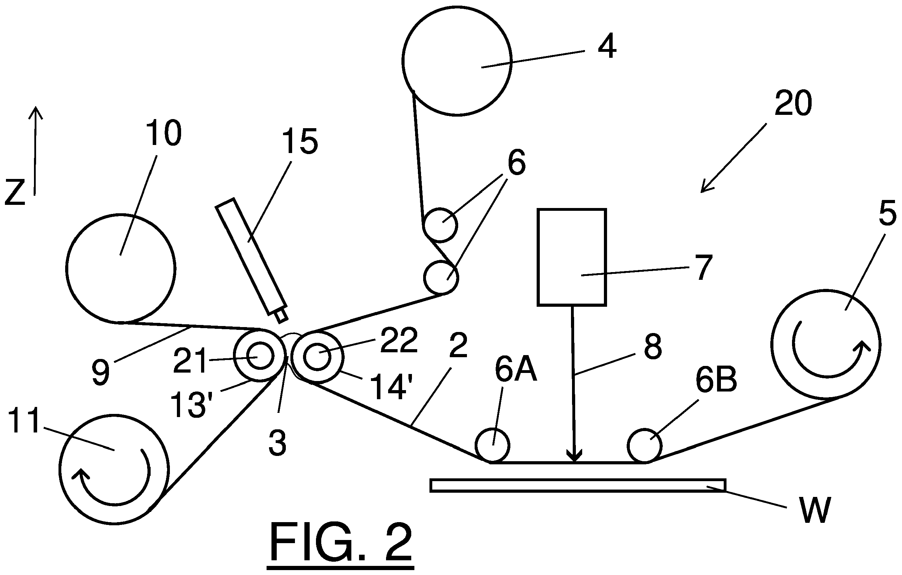

Various embodiments of the present invention will now be described with reference to FIGs. 2 to 4. In these figures, for simplicity and consistency, reference numerals will be maintained for similar items as far as possible.

A first embodiment of the present invention is shown in FIG. 2. This shows a LAD apparatus 20, which has many similarities to the apparatus 10 shown in FIG. 1. This apparatus 20 however, comprises a coating section for coating a first major surface of the tape 2 with deposition medium such as solder paste 3, which is applied to the first major surface from a deposition material source here in the form of a paste dispenser 15, including first and second vibration units in the form of ultrasonic transducers 21, 22 linked to, and as shown in FIG. 2 embedded within, respective regulating members in the form of rollers 13', 14'. The ultrasonic transducers 21, 22 may for example be integrally formed with the respective axles of the rollers 13', 14'. As with the apparatus 10 of FIG. 1, the rollers 13', 14' are arranged downstream of the paste dispenser 15 along the movement path, and in spaced relation on either side of the tape such that the distance between the first and second rollers regulates the thickness of solder paste 3 coated onto the first major surface of the tape 2 in use. In use, the ultrasonic transducers 21, 22 are switched on while the coating process is performed, with the resulting vibration being transferred via rollers 13', 14' to the applied solder paste 3 at the coating section. The solder paste 3, due to its thixotropic nature, becomes less viscous, aiding consistency and quality of coating onto tape 2.

In FIG. 2, ultrasonic transducers are used in each of the rollers 13', 14'. In other embodiments, a single vibration unit may be provided, associated with a single one of the rollers 13', 14'.

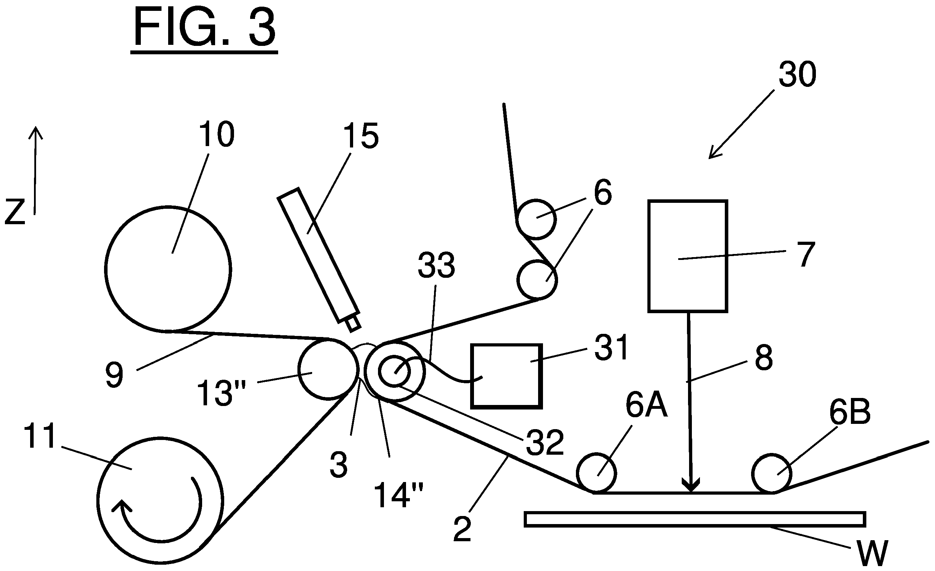

The embodiment described above with reference to FIG. 2 used vibration units comprising vibration generators mounted to respective regulating members. FIG. 3 schematically shows, in an expanded view from the side, part of a LAD apparatus 30 in accordance with a second embodiment of the present invention, in which a vibration unit is used which comprises a vibration generator which is linked to a respective regulating member via a waveguide. In FIG. 3, the vibration generator, here an ultrasonic generator 31 is linked to roller 14" via an ultrasonic waveguide schematically shown at 33. The waveguide 33 may, as shown, connect with an axle 32 of the roller 14". The axle 32 may optionally be hollow. Operation of the apparatus 30 is very similar to that of apparatus 20 shown in FIG. 2. Although the ultrasonic generator 31 is shown as being linked to one roller 14" only, in other embodiments (not shown) it may be connected to the other roller 13" instead, or additionally. In this latter case, such linking may be provided by two respective ultrasonic waveguides (not shown). Alternatively, a separate vibration unit (not shown), may be provided which is linked to roller 13".

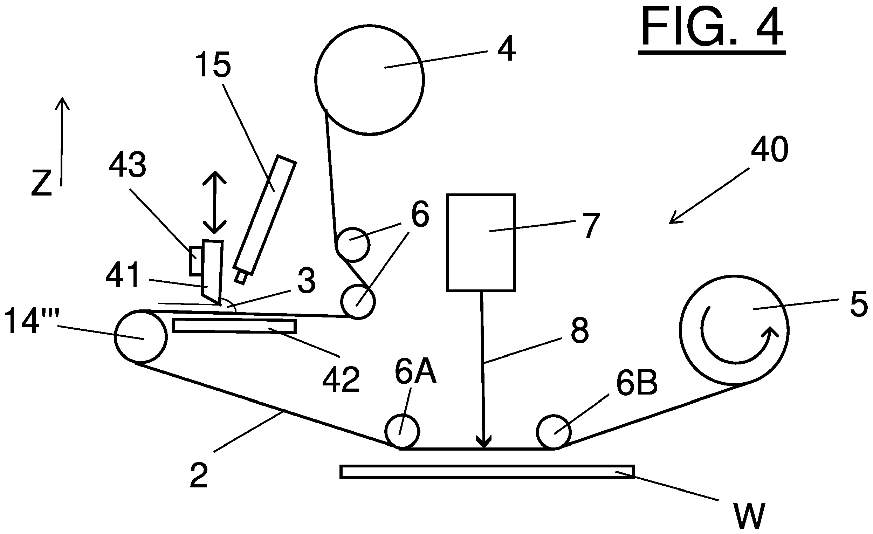

FIG. 4 schematically shows, from the side, a LAD apparatus 40 in accordance with a further embodiment of the present invention. In this embodiment, the coating section comprises first and second regulating members in the form of a doctor blade 41 lying above a tape support surface 42 which is flat at least in the region proximate the lower edge of the doctor blade 41. The doctor blade 41 is preferably adjustable in the vertical or Z direction as shown, to permit the required coating thickness of solder paste 3 to be adjusted, which in all cases is determined by the gap between the tape support surface 42 and the lower edge of the doctor blade 41. The doctor blade 41 has a vibration unit in the form of an ultrasonic transducer 43 mounted thereto. When switched on, the ultrasonic transducer 43 transmits ultrasonic vibration to the doctor blade 41, which in turn transmits vibration to the applied solder paste 3, lowering its viscosity for improved coating.

In alternative embodiments, the vibration unit associated with the doctor blade may comprise a vibration generator, preferably an ultrasonic vibration generator, linked to the doctor blade 41 via a waveguide, similarly to the embodiment shown in FIG. 3.

Furthermore, a vibration unit may be provided in association with the other regulating member, i.e. the tape support surface 42, either additionally or alternatively to the vibration unit associated with the doctor blade 41.

In laser-assisted deposition apparatus according to the present invention, such as in any of the specific embodiments described above, the vibration unit may produce vibration at a range of frequencies. Ultrasonic vibration is preferred, with vibration in the frequency range from about 20 kHz to about 200 kHz being particularly preferred, in one embodiment at a frequency of at least about 30 kHz, in one embodiment at a frequency of at most about 100 kHz, preferably at most about 80 kHz, more preferably at most about 60 kHz and still more preferably at most about 50 kHz. In practice however, the ideal vibration frequency may depend on the type of deposition material being used. It is therefore advantageous if the vibration frequency of the vibration units used are adjustable, to cater for a variety of different deposition media.

The above-described embodiments are exemplary only, and other possibilities and alternatives within the scope of the invention will be apparent to those skilled in the art.

### Reference numerals used:

1 - LAD apparatus
2 - Deposition tape
3 - Solder paste
4 - Deposition tape store reel
5 - Used tape reel
6, 6A, 6B - Rollers
7 - Laser source
8 - Laser beam
9 - Coating tape
10 - Coating tape store reel
11 - Coating tape used reel
12 - Paste application zone
13, 13', 13", 14, 14', 14", 14‴ - Rollers
15 - Paste dispenser
20 - LAD apparatus
21, 22 - Ultrasonic transducers
30 - LAD apparatus
31 - Ultrasonic generator
32 - Axle
33 - Ultrasonic waveguide
40 - LAD apparatus
41 - Doctor blade
42 - Tape support surface
43 - Ultrasonic transducer
W - Workpiece

## Claims

1. A laser-assisted deposition apparatus for depositing deposition medium from a tape onto a workpiece, the tape having two major surfaces, the laser-assisted deposition apparatus comprising:
a tape advancement mechanism for moving the tape through the laser-assisted deposition apparatus along a movement path,
a coating section for coating a first major surface of the tape with deposition medium,
a laser source operative to direct a laser beam onto a second surface of the tape at an illumination region thereof, and
a workpiece support for supporting a workpiece proximate the first surface, such that deposition medium, located on the first surface thereof and in alignment with the illumination region, is expelled from the second surface onto the workpiece when the laser beam is directed to the illumination region,
wherein the coating section comprises:
a deposition material source for applying deposition material to the first major surface,
first and second regulating members arranged downstream of the deposition material source along the movement path, and in spaced relation on either side of the tape such that the distance between the first and second regulating members regulates the thickness of deposition material coated onto the first major surface of the tape in use, and
a vibration unit which is operative to agitate the deposition material at the coating section.

2. A laser-assisted deposition apparatus according to claim 1, wherein the vibration unit is linked to the first regulating member to effect vibration of the first regulating member.

3. A laser-assisted deposition apparatus according to claim 2, wherein the vibration unit comprises a vibration generator which is mounted to the first regulating member.

4. A laser-assisted deposition apparatus according to claim 2, wherein the vibration unit comprises a vibration generator which is linked to the first regulating member via a waveguide.

5. A laser-assisted deposition apparatus according to any of claims 2 to 4, comprising a second vibration unit, which is linked to the second regulating member to effect vibration of the second regulating member.

6. A laser-assisted deposition apparatus according to any preceding claim, wherein the vibration unit comprises an ultrasonic transducer.

7. A laser-assisted deposition apparatus according to claim 6, wherein the ultrasonic transducer produces vibration in the frequency range 20 kHz to 200 kHz, optionally at least about 30 kHz, optionally at a frequency of at most about 100 kHz, optionally at most about 80 kHz, optionally at most about 60 kHz; optionally at most about 50 kHz.

8. A laser-assisted deposition apparatus according to any preceding claim, wherein the first regulating member comprises a roller.

9. A laser-assisted deposition apparatus according to claim 8, wherein the second regulating member comprises a roller.

10. A laser-assisted deposition apparatus according to claim 8, wherein the second regulating member comprises a flat tape support surface.

11. A laser-assisted deposition apparatus according to any of claims 1 to 7, wherein the first regulating member comprises a doctor blade and the second regulating member comprises a flat tape support surface.

12. A method for depositing deposition medium from a tape onto a workpiece, the tape having two major surfaces, the method comprising the steps:
i) providing a laser-assisted deposition apparatus,
ii) moving the tape through the laser-assisted deposition apparatus along a movement path,
iii) coating a first major surface of the tape with deposition medium at a coating section of the laser-assisted deposition apparatus, and
iv) directing a laser beam onto a second surface of the tape at an illumination region thereof, such that deposition medium, located on the first surface thereof and in alignment with the illumination region, is expelled from the second surface onto the workpiece when the laser beam is directed to the illumination region,
wherein step iii) comprises applying deposition material to the first major surface,
passing the tape with deposition material applied to the first major surface between first and second regulating members, to regulate the thickness of deposition material coated onto the first major surface of the tape, and
agitating the deposition material at the coating section.

13. The method of claim 12, wherein the deposition material is agitated by applying ultrasonic vibration.

14. The method of claim 13, wherein the ultrasonic vibration is applied in the frequency range 20 kHz to 200 kHz, optionally at least about 30 kHz, optionally at a frequency of at most about 100 kHz, optionally at most about 80 kHz, optionally at most about 60 kHz; optionally at most about 50 kHz.
